# EUROPEAN PATENT SPECIFICATION

(11) **EP 3 379 571 B1**
(45) Date of publication and mention of the grant of the patent: **25.06.2025**
(21) Application number: 17762479.8
(22) Date of filing: 27.02.2017
(51) Int. Cl.: H10K 59/131, H10D 86/40, H01L 23/49, H10D 86/60, H10K 102/00

(54) **WIRE AND METHOD FOR MANUFACTURING SAME**
DRAHT UND VERFAHREN ZUR HERSTELLUNG DAVON
FIL ET PROCÉDÉ POUR SA FABRICATION

(30) Priority: 09.03.2016 CN 201610132850
(43) Date of publication of application: 26.09.2018
(73) Proprietor: Kunshan New Flat Panel Display Technology Center Co., Ltd., Photoelectric Industrial Park Development Zone Kunshan Jiangsu 215300 (CN)
(72) Inventor: HU, Kun, Kunshan Jiangsu 215300 (CN); LIN, Li, Kunshan Jiangsu 215300 (CN); SHAN, Qi, Kunshan Jiangsu 215300 (CN); CAI, Shixing, Kunshan Jiangsu 215300 (CN); YANG, Xiaolong, Kunshan Jiangsu 215300 (CN); LIU, Shengfang, Kunshan Jiangsu 215300 (CN)
(74) Representative: Kraus & Lederer PartGmbB
(86) International application number: PCT/CN2017/075070
(87) International publication number: WO 2017/152793

(56) References cited:
- WO-A1-2016/032175
- CN-A- 103 730 476
- CN-A- 103 730 476
- CN-A- 105 047 676
- CN-U- 201 788 721
- CN-U- 205 406 511
- JP-A- 2009 259 929
- US-A1- 2011 278 550
- US-A1- 2014 055 702
- US-A1- 2014 118 975
- US-A1- 2014 217 373
- US-B1- 9 276 055

## Description

### FIELD OF THE DISCLOSURE

The disclosure relates to the technical field of thin film transistor backplane, and in particular to a wire and a method for manufacturing a wire.

### BACKGROUND

An organic light-emitting diode (OLED for short) is considered to be one of the most promising display technologies for its characteristics such as high luminance, wide viewing angle, lower power consumption and wide working temperature. One of the biggest advantages of an OLED device, as a fully-cured display device, is that it can achieve flexible display, and can be used to manufacture a foldable electronic newspaper, a rollable wall-hanging television and a wearable display and so on, so as to exhibit fascinations of organic semiconductors.

In practical applications, the thin film transistor backplane of the OLED device includes a plurality of circuits, and different circuits are connected by wires. However, as for the manufactured OLED devices, such as the foldable electronic newspaper, the rollable wall-hanging television and the wearable display, the wire will be bent at portions where need to be folded. Although the wire itself has a certain degree of ductility, too long time of folding or too many times of folding will crack the wire. Once the wire fractures, normal use of the entire OLED device will be affected.

At present, in order to solve the above problem, the whole industry proposes a method in which the wires are fixed on the thin film transistor backplane by employing a manner of drilling holes and fixing. However, in practical applications, such manner is still hard to avoid the problem of wire fracture during folding.

WO2016032175 (also published as US 9276055B1) discloses a flexible display, and reference can be made to figure 8a-8d. the diamond trace design shown in FIG.8 provides a significant electrical advantage over the single wire trace designs of the FIG.7. Splitting of the trace into multiple sub-traces may provide a backup eletrical pathway in case one of the sub-traces is damaged by cracks. As such, the diamond trace design can be used for the wire traces in the bend portion, and may be particularly helpful for the wire traces within the bend allowance section subjected to severe bending stress.

JP 2009259929A provides a flexible wiring board which is thin in mounting thickness and elastic. The flexible printed board 1 is provided with wiring at a base portion, and includes a hole portion 2 formed penetrating the base portion, a deformable portion 3 formed of the base portion enclosing a periphery of the hole portion 2 and capable of curving in an extension direction with tensile force to deform, and a wiring portion 6 formed at the deformable portion 3 from an input end 4 to an output end 5 while bypassing the hole portion 2. The hole portion 2 is shaped to have a different aspect ratio. A plurality of hole portions 2 are formed. The plurality of hole portions 2 have diagonals made longer other in the extension direction than that in the extension direction, and sides of the hole portions 2 are arranged opposite each other.

US 20140118975A1 discloses an environmental sensitive electronic device package. The environmental sensitive electronic device package may include a first substrate, a second substrate, an environmental sensitive electronic device, at least one side wall barrier structure, and a filler layer. The first substrate has at least one predetermined flexure area. The second substrate is located above the first substrate. The environmental sensitive electronic device is located on the first substrate and between the first substrate and the second substrate. The side wall barrier structure is located between the first substrate and the second substrate and surrounds the environmental sensitive electronic device. The side wall barrier structure has at least one flexure stress dispersing structure that is located in the predetermined flexure area.The filler layer is located between the first substrate and the second substrate and covers the side wall barrier structure and the environmental sensitive electronic device.

US 20140217373A1 provides a flexible display substrate, a flexible organic light emitting display device, and a method of manufacturing the same. The flexible display substrate comprises a flexible substrate including a display area and a non-display area extending from the display area, a first wire formed on the display area of the flexible substrate, and a second wire formed on the non-display area of the flexible substrate, wherein at least a part of the non-display area of the flexible substrate is curved in a bending direction, and the second wire formed on at least a part of the non-display area of the flexible substrate includes a first portion formed to extend in a first direction and a second portion formed to extend in a second direction.

CN103730476A1 provides an array substrate and a display device. The array substrate comprises grid lines, data lines and a plurality of pixel units which are defined by intersection of the grid lines and the data lines, wherein a first anti-fracture structure is formed on each grid line, and/or a second anti-fracture structure is formed on each data line. According to the array substrate, due to the fact that the anti-fracture structures are formed on patterns of the grid lines and/or the data lines, when a flexible display device is bent, part of tension can be dispersed through the anti-fracture structures, the probability that the grid lines and the data lines are fractured when the flexible display device is bent can be reduced, and normal display of the flexible display device can be guaranteed.

US2014/055702A1 provides a display with an active central region and a peripheral inactive region. The display may have one or more flexible edges in the peripheral inactive region. Conductive lines may pass between components in the active central region such as display pixels and touch sensor electrodes and components in the inactive peripheral region such as gate driver circuitry and patterned interconnect lines. Each conductive line may have an unbent segment on a portion of a display layer in the active central region and may have a segment on the bent edge of the display layer. The display layer may be formed from a polymer or other flexible material. The bent segments may be configured to be less susceptible to increases in resistance from bending than the unbent segments.

### SUMMARY

In view of the above, the embodiments of the disclosure provide a wire and a method of manufacturing the same, aiming to solve the problem of OLED device unable to be normally used during folding due to wire fracture which is inevitable in the prior art.

A wire for use in an organic light-emitting diode (OLED) device in accordance with the present invention is defined in claim 1. A method of manufacturing such wiring is defined in claim 2.

### Advantageous effects:

By dividing a middle part of one wire into multiple wires, the purpose of changing a wire width of a single wire is achieved, which not only has no influence on use of the wires in the OLED device, but also enhances ductility of the wires, thereby efficiently avoiding the occurrence of the problem that the OLED device cannot normally work caused by wire fracture during folding, and efficiently improving the using efficiency of the OLED.

### BRIEF DESCRIPTION OF THE DRAWINGS

In order to more clearly describe the technical solution in the embodiments of the disclosure, in the following, a brief introduction will be made to the accompanying drawings used in the embodiments.
FIG.1 is a structural schematic view of a wire provided in a first embodiment of the disclosure;
FIG.2 is a structural schematic view of a wire provided in a second embodiment of the disclosure;
FIG.3 is a structural schematic view of a wire provided in a third embodiment of the disclosure;
FIG.4 is a schematic flowchart of a method for manufacturing a wire provided in embodiments of the disclosure.

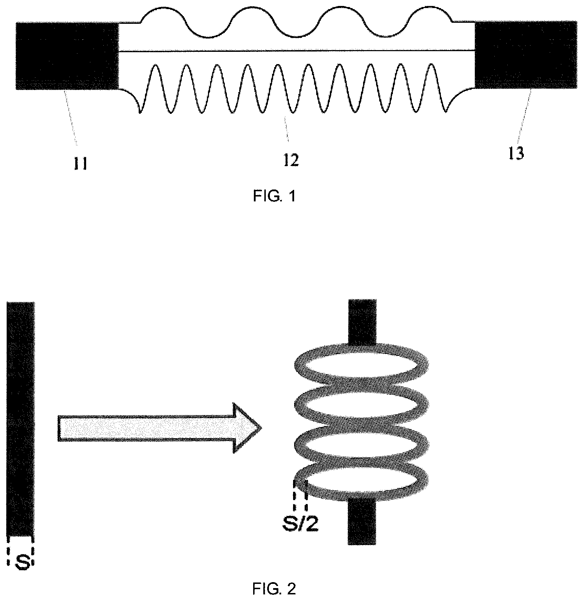

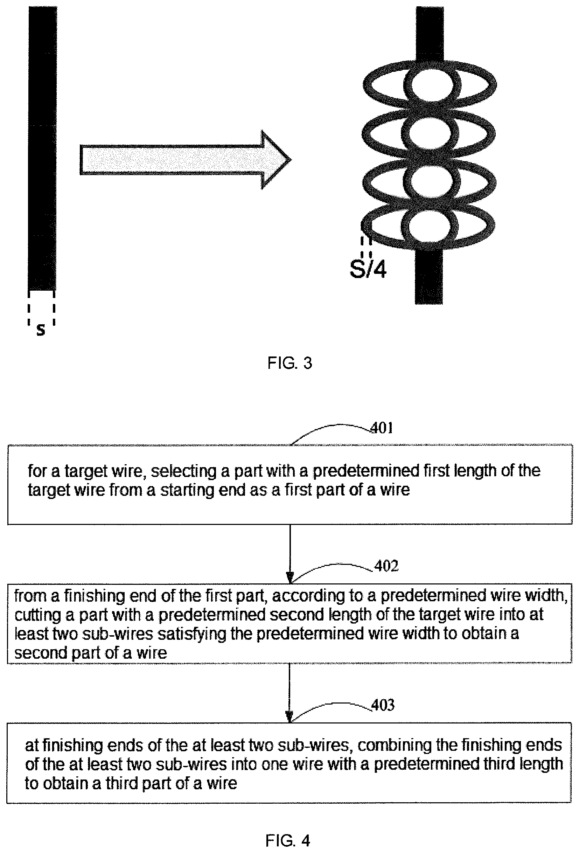

The embodiments of figures 1 and 2 do not form par of the present invention but are useful to understand it. The embodiment of figure 3 corresponds to the embodiment of the present invention. The embodiment of figure 4 is directed to the manufacture of the wiring of figure 3.

### DETAILED DESCRIPTION OF PREFERRED EMBODIMENTS

To achieve an object of the disclosure, the embodiments of the disclosure provide a wire for use in an organic light-emitting diode (OLED) device and a method for manufacturing the wire, wherein the wire comprises three parts, and a first part and a third part are located at both ends of the wire respectively and each of the first part and third part is a single wire; a second part is located between the first part and the third part and is a composite wire, wherein the composite wire comprises at least two wires. By dividing a middle part of one wire into multiple wires, the purpose of changing a wire width of a single wire is achieved, which not only has no influence on use of the wire in the OLED device, but also enhances ductility of the wire, thereby efficiently avoiding the occurrence of the problem that the OLED device cannot normally work caused by wire fracture during folding, and efficiently improving the using efficiency of the OLED.

FIG. 1 is a structural schematic view of a wire provided in a first embodiment of the present disclosure not forming part of the present invention but useful to understand it. The wire comprises three parts, wherein a first part 11 and a third part 13 are located at both ends of the wire respectively and each of the first part 11 and third part 13 is a single wire; a second part 12 is located between the first part and the third part and is a composite wire, wherein the composite wire comprises at least two wires.

A wire, as a relatively important element inside the OLED device, determines whether the OLED device is able to work normally. A study teaches that the wire widths and bending lives of wires have following relationships, as shown in Table 1:

**Table 1**

| | 3µm | 5µm | 10µm |
|---|---|---|---|
| Folded wire | 65000 times | 10000 times | 5000 times |
| Straight wire | 75000 times | 65000 times | 30000 times |
| Curved wire | 95000 times | 70000 times | 35000 times |

As can be seen from Table 1, for the wires having the same shapes, the larger the wire widths of the wires are, the shorter the bending lives of the wires are, which is mainly because defects inside metal lines in the wires are increased, since the wire widths are increased, leading to relative concentration of the stress in the curved areas, cracks being prone to propagate, reducing the bending lives of the wires; the wires having the longest bending lives among the wires having the same wire widths belong to the curved wires, which is mainly because the curved wires are relatively suitable for releasing the stress when the wires are bent and fatigued; the stress of the folded wires are easily concentrated and accumulated at corners, thereby generating cracks and leading to fatigue failure, and reducing the bending lives of the wires.

Moreover, in the OLED device, the both ends for making the wire to be fixed (i.e., the first part and the third part), when being fixed, are also prone to fracture owing to being too thin. Thus the first part and the third part use a single wire, and the second wire uses a composite wire, so as to prolong the bending lives of the wires inside the OLED device.

In this way, in one wire, a middle part uses a smooth curve. When a middle part is bent, the stress distribution may become even, thereby avoiding a phenomenon of stress concentration and effectively avoiding the occurrence of the wire fracture.

In addition, since a middle part of the wire uses a composite wire, other wires may be in normal use even if fracture occurs to one of the wires, which will not affect normal use of the entire OLED device.

FIG.2 is a structural schematic view of a wire provided in a second embodiment of the present disclosure not forming part of the present invention but useful to understand it.

As can be seen from FIG.2, cross-sectional areas of the first part and the third part of the wire are S, and a cross-sectional area of the second part is S/2; wherein the shape of the second part of the wire is elliptical.

FIG.3 is a structural schematic view of a wire provided in a third embodiment of the present disclosure which represents the present invention.

As can be seen from FIG.3, cross-sectional areas of the first part and the third part of the wire are S, and a cross-sectional area of the second part is S/4; wherein the shape of the second part of the wire is elliptical and circular.

The wires shown in FIG.2 and FIG.3 not only have no effect on use of the wires in the OLED device, but also enhance ductility of the wires, and the parts having been folded and curved of the wires are made into elliptical shape, the problem that the OLED device cannot normally work caused by wire fracture during folding can be avoided efficiently, thereby efficiently improving the using life of the OLED.

The embodiments of the disclosure provide a wire for use in an organic light-emitting diode (OLED) device, wherein the wire comprises three parts, and a first part and a third part are located at both ends of the wire respectively and each of the first part and the third part is a single wire; a second part is located between the first part and the third part and is a composite wire, wherein the composite wire comprises at least two wires. By dividing a middle part of one wire into multiple wires, the purpose of changing a wire width of a single wire is achieved, which not only has no influence on use of the wires in the OLED device, but also enhances ductility of the wires, thereby efficiently avoiding the occurrence of the problem that the OLED device cannot normally work caused by wire fracture during folding, and efficiently improving the using life of the OLED.

FIG.4 is a schematic flowchart of a method for manufacturing a wire provided in an embodiment of the disclosure. The method may be as follows.

Step 401: for a target wire, selecting a predetermined first length of the target wire from a starting end as a first part of the target wire.

The predetermined length here may be set according to requirements for the OLED device and is not limited by the embodiment of the disclosure.

Step 402: from a finishing end of the first part, according to a predetermined wire width, cutting the wire with a predetermined second length into at least two sub-wires satisfying the predetermined wire width to obtain a second part of the target wire.

In Step 402, cutting the wire with a predetermined second length into at least two sub-wires satisfying the predetermined wire width may be made by adopting a manner of photo etching or other manners, and may also be made by employing a mask with a pattern of this wire to manufacture directly, which is not limited herein.

Step 403: at finishing ends of the at least two sub-wires, combining the finishing ends of the at least two sub-wires into one wire to obtain a third part of the target wire.

The solution of manufacturing a wire provided by the embodiment of the disclosure not only has no influence on use of the wires in the OLED device, but also enhance ductility of the wires, thereby efficiently avoiding the occurrence of the problem that the OLED device cannot normally work caused by wire fracture during folding, and efficiently improving the using efficiency of the OLED.

## Claims

1. A wire for use in an organic light-emitting diode (OLED) device, the wire comprises a first part (11), a second part (12) and a third part (13), which are connected to each other, the first part (11) and the third part (13) are located at both ends of the wire respectively, wherein each of the first part (11) and third part (13) is a single wire; and
the second part (12) is located between the first part (11) and the third part (13) and is a composite wire, wherein the composite wire comprises at least two sub-wires;
**characterized in that** the composite wire comprises first, second, third and fourth sub-wires diverging and converging to form several loops in a row connected to each other and connecting the first part with the third part, each loop comprising the first and fourth sub-wires forming an outer loop having an elliptical shape which surrounds an inner loop having a circular shape and which is formed by the second and third sub-wires, wherein the width (S/4) of each of the first to fourth sub-wires is equal to a fourth of the width (s) of the wire at the first part and third part, the wires at the first part and third part having the same width (s),
wherein the outer loop has a same diameter as the inner loop in a longitudinal direction of the wire, and has a larger diameter than the diameter of the inner loop in a transverse direction perpendicular to the longitudinal direction of the wire.

2. A method for manufacturing a wire according to claim 1, the method comprising:
for a target wire, selecting (401) a predetermined first length of the target wire from a starting end as a first part (11) of the target wire;
from a finishing end of the first part (11), according to a predetermined wire width, cutting (402) the wire with a predetermined second length into the first to fourth sub-wires, wherein the width (S/4) of each of the first to fourth sub-wires is equal to a fourth of the width (s) of the wire at the first part (11) and the third part (13), in order to obtain a second part (12) of the target wire;
at finishing ends of the first to fourth sub-wires, combining (403) the finishing ends of the first to fourth sub-wires into one wire to obtain a third part (13) of the target wire;
wherein making the composite wire comprise first, second, third and fourth sub-wires diverging and converging to form several loops in a row connected to each other and connecting the first part with the third part, each loop comprising the first and fourth sub-wires forming an outer loop having an elliptical shape which surrounds an inner loop having a circular shape and which is formed by the second and third sub-wires, wherein the width (S/4) of each of the first to fourth sub-wires is equal to a fourth of the width of the wire at the first part and third part, the wires at the first part and the third part having the same width,
wherein the outer loop has a same diameter as the inner loop in a longitudinal direction of the wire, and has a larger diameter than the diameter of the inner loop in a transverse direction perpendicular to the longitudinal direction of the wire.

## Patentansprüche

1. Draht zur Verwendung in einer organischen Leuchtdiode (OLED), wobei der Draht einen ersten Teil (11), einen zweiten Teil (12) und einen dritten Teil (13) umfasst, die miteinander verbunden sind, wobei sich der erste Teil (11) und der dritte Teil (13) jeweils an beiden Enden des Drahtes befinden, wobei sowohl der erste Teil (11) als auch der dritte Teil (13) ein einzelner Draht ist; und
der zweite Teil (12) sich zwischen dem ersten Teil (11) und dem dritten Teil (13) befindet und ein Verbunddraht ist, wobei der Verbunddraht mindestens zwei Unterdrähte umfasst;
**dadurch gekennzeichnet, dass** der Verbunddraht erste, zweite, dritte und vierte Unterdrähte umfasst, die auseinander laufen und konvergieren, um in einer Reihe mehrere Schleifen zu bilden, die miteinander verbunden sind und den ersten Teil mit dem dritten Teil verbinden, wobei jede Schleife umfassend den ersten und den vierten Unterdraht eine äußere Schleife mit einer elliptischen Form bildet, die eine innere Schleife mit einer kreisförmigen Form umgibt, die durch den zweiten und den dritten Unterdraht gebildet wird, wobei die Breite (S/4) jedes der ersten bis vierten Unterdrähte einem Viertel der Breite (s) des Drahtes am ersten Teil und am dritten Teil gleich ist, wobei die Drähte am ersten Teil und am dritten Teil die gleiche Breite (s) aufweisen,
wobei die äußere Schleife den gleichen Durchmesser wie die innere Schleife in einer Längsrichtung des Drahtes aufweist und einen größeren Durchmesser als der Durchmesser der innere Schleife in einer Querrichtung senkrecht zu der Längsrichtung des Drahtes aufweist.

2. Verfahren zur Herstellung eines Drahtes nach Anspruch 1, das Verfahren umfassend:
Auswählen (401), für einen Zieldraht, einer vorbestimmten ersten Länge des Zieldrahtes ausgehend von einem Anfangsende als ein erster Teil (11) des Zieldrahtes;
Schneiden (402) des Drahts mit einer vorbestimmten zweiten Länge in die ersten bis vierten Unterdrähte ausgehend von einem Abschlussende des ersten Teils (11) nach einem vorbestimmten Breite des Drahtes, wobei die Breite (S/4) jedes der ersten bis vierten Unterdrähte einem Viertel der Breite (s) des Drahts am ersten Teil (11) und am dritten Teil (13) gleich ist, um einen zweiten Teil (12) des Zieldrahts zu erhalten;
Kombinieren (403), an den Abschlussenden des ersten bis vierten Unterdrahtes, der Abschlussenden des ersten bis vierten Teildrahtes zu einem Draht, um einen dritten Teil (13) des Zieldrahtes zu erhalten;
wobei das Herstellen des Verbunddrahtes erste, zweite, dritte und vierte Unterdrähte umfasst, die auseinander laufen und konvergieren, um in einer Reihe mehrere Schleifen zu bilden, die miteinander verbunden sind und den ersten Teil mit dem dritten Teil verbinden, wobei jede Schleife umfassend die ersten und vierten Unterdrähte eine äußere Schleife mit einer elliptischen Form bildet, die eine innere Schleife mit einer kreisförmigen Form umgibt und die durch die zweiten und dritten Unterdrähte gebildet wird, wobei die Breite (S/4) jedes der ersten bis vierten Teildrähte einem Viertel der Breite des Drahtes am ersten Teil und am dritten Teil gleich ist, wobei die Drähte am ersten Teil und am dritten Teil die gleiche Breite aufweisen,
wobei die äußere Schleife den gleichen Durchmesser wie die innere Schleife in einer Längsrichtung des Drahtes aufweist und einen größeren Durchmesser als der Durchmesser der innere Schleife in einer Querrichtung senkrecht zu der Längsrichtung des Drahtes aufweist.

## Revendications

1. Fil destiné à être utilisé dans un dispositif de diode électroluminescente organique (OLED), le fil comprend une première partie (11), une deuxième partie (12) et une troisième partie (13), qui sont reliées l'une à l'autre, la première partie (11) et la troisième partie (13) étant situées respectivement aux deux extrémités du fil, la première partie (11) et la troisième partie (13) étant chacune un fil unique ; et
la deuxième partie (12) est située entre la première partie (11) et la troisième partie (13) et est un fil composite, le fil composite comprenant au moins deux fils secondaires ;
**caractérisé en ce que** le fil composite comprend des premier, deuxième, troisième et quatrième fils secondaires divergeant et convergeant pour former plusieurs boucles dans une rangée reliée les unes aux autres et reliant la première partie à la troisième partie, chaque boucle comprenant les premier et quatrième fils secondaires formant une boucle extérieure de forme elliptique qui entoure une boucle intérieure de forme circulaire et étant formée par les deuxième et troisième fils secondaires, la largeur (S/4) de chacun des premier à quatrième fils secondaires étant égale à un quart de la largeur (s) du fil au niveau de la première partie et de la troisième partie, les fils au niveau de la première partie et de la troisième partie ayant la même largeur (s),
la boucle extérieure ayant le même diamètre que la boucle intérieure dans une direction longitudinale du fil et ayant un diamètre supérieur à celui de la boucle intérieure dans une direction transversale perpendiculaire à la direction longitudinale du fil.

2. Procédé de fabrication d'un fil selon la revendication 1, le procédé comprenant :
pour un fil cible, la sélection (401) d'une première longueur prédéterminée du fil cible à partir d'une extrémité de départ en tant que première partie (11) du fil cible ;
à partir d'une extrémité de finition de la première partie (11), selon une largeur de fil prédéterminée, la coupe (402) du fil d'une deuxième longueur prédéterminée en un premier à un quatrième fils secondaires, la largeur (S/4) de chacun des premier à quatrième fils secondaires étant égale à un quart de la largeur (s) du fil au niveau de la première partie (11) et de la troisième partie (13), afin d'obtenir une deuxième partie (12) du fil cible ;
aux extrémités de finition des premier à quatrième fils secondaires, la combinaison (403) des extrémités de finition des premier à quatrième fils secondaires en un seul fil pour obtenir une troisième partie (13) du fil cible ;
la fabrication du fil composite comprenant des premier, deuxième, troisième et quatrième fils secondaires divergeant et convergeant pour former plusieurs boucles dans une rangée reliées les unes aux autres et reliant la première partie à la troisième partie, chaque boucle comprenant les premier et quatrième fils secondaires formant une boucle extérieure de forme elliptique qui entoure une boucle intérieure de forme circulaire et étant formée par les deuxième et troisième fils secondaires, la largeur (S/4) de chacun des premier à quatrième fils secondaires étant égale à un quart de la largeur du fil au niveau de la première partie et de la troisième partie, les fils au niveau de la première partie et de la troisième partie ayant la même largeur,
la boucle extérieure ayant le même diamètre que la boucle intérieure dans une direction longitudinale du fil et ayant un diamètre supérieur à celui de la boucle intérieure dans une direction transversale perpendiculaire à la direction longitudinale du fil.
